# EUROPEAN PATENT APPLICATION

(11) **EP 1 548 076 A1**
(43) Date of publication of application: **29.06.2005**
(21) Application number: 04257741.1
(22) Date of filing: 13.12.2004
(51) Int. Cl.: C09G 1/04, C09K 3/14

(54) **Compositions and methods for low downforce pressure polishing of copper**

(30) Priority: 22.12.2003 US 742961
(71) Applicant: Rohm and Haas Electronic Materials CMP Holdings, Inc., Wilmington, DE 19899 (US)
(72) Inventor: Goldberg, Wendy B., Sequim, WA 98382 (US); Kelley, Francis J., Bear, DE 19701 (US); Quanci, John, Haddonfield, NJ 08033 (US); So, Joseph K., Newark, DE 19711 (US); Thomas, Terence M., Newark, DE 19711 (US); Wang, Hongyu, Wilmington, DE 19808 (US)
(74) Representative: Buckley, Guy Julian

(57) **Abstract**

The present invention provides an aqueous composition useful for polishing copper on a semiconductor wafer at a down force pressure of at least less than 20.68 kPa, comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive, wherein the phosphorus-containing compound increases removal of the copper.

## Description

### BACKGROUND OF THE INVENTION

The invention relates to chemical mechanical planarization (CMP) of semiconductor wafer materials and, more particularly, to CMP compositions and methods for polishing copper interconnects from semiconductor wafers in the presence of dielectrics and barrier materials.

Typically, a semiconductor wafer has a wafer of silicon and a dielectric layer containing multiple trenches arranged to form a pattern for circuit interconnects within the dielectric layer. The pattern arrangements usually have a damascene structure or a dual damascene structure. A barrier layer covers the patterned dielectric layer and a metal layer covers the barrier layer. The metal layer has at least sufficient thickness to fill the patterned trenches with metal to form circuit interconnects.

CMP processes often include multiple polishing steps. For example, a first step removes a metal layer from underlying barrier and dielectric layers. The first step polishing removes the metal layer, while leaving a smooth planar surface on the wafer with metal-filled trenches that provide circuit interconnects planar to the polished surface. First step polishing removes excess interconnect metals, such as copper at an initial high rate. After the first step removal, the second step polishing can remove a barrier that remains on the semiconductor wafer. This second step polishing removes the barrier from an underlying dielectric layer of a semiconductor wafer to provide a planar polished surface on the dielectric layer. The CMP is typically conducted at down force pressures of about 3 psi (20.68 kPa).

Unfortunately, the transition to ultra low k dielectric films require that the CMP be performed at lower pressures to avoid delamination of the films. However, decreasing the down force pressures negatively impacts the overall performance, including the polishing rate, of CMP. For example, the polishing rate for a conventional first step slurry is reduced to about 1000 Å/min when the pressure is reduced to about 1 psi, compared to about 3000 Å/min at 3 psi. Hence, when the pressure is decreased, the throughput is significantly impacted.

Kaufman et al. (U.S. Patent No. 6,620,037), discloses a typical slurry composition for polishing copper. The composition of Kaufman eliminates a film forming agent (e.g., BTA) in an attempt to increase polishing rates. However, the composition still requires a down force of 3 psi or greater to be effective for removing copper (the composition of Kaufman provides a polishing rate of 2346 Å/min at 3 psi). Consequently, the disclosure of Kaufman still suffers from the above-noted problems.

Hence, what is needed is an improved polishing composition and method for effectively polishing copper interconnects with reduced down force pressures. In particular, there is a need for a composition and method for effectively polishing copper interconnects with down force pressures of 1 psi and less for ultra low dielectric applications.

### STATEMENT OF THE INVENTION

In a first aspect, the present invention provides an aqueous composition useful for polishing copper on a semiconductor wafer at a down force pressure of at least less than 20.68 kPa, comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive, wherein the phosphorus-containing compound increases removal of the copper.

In a second aspect, the present invention provides an aqueous composition useful for polishing copper on a semiconductor wafer comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive, wherein the phosphorus-containing compound increases removal of the copper to at least 1500 Å/min as measured with a microporous polyurethane polishing pad pressure measured normal to the wafer of 6.89 kPa.

In a third aspect, the present invention provides a method for polishing copper from a semiconductor wafer comprising: contacting the wafer with a polishing composition, the wafer containing the copper, the polishing composition comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive; pressing the wafer with a polishing pad at a down force pressure of at least less than 20.68 kPa; and polishing the wafer with the polishing pad, wherein the phosphorus-containing compound increases removal of the copper.

### DETAILED DESCRIPTION

The composition and method provide unexpected increase in polishing rates of copper interconnects at low down force pressures. The composition of the present invention utilizes the addition of phosphorus-containing compounds to effectively increase first step polishing rates of copper interconnects on the wafer at reduced down force pressures. The invention is particularly useful in ultra low k dielectric film applications. Also, although the present invention has particular usefulness in copper interconnects, the present aqueous polishing composition also provides enhanced polishing of other metal interconnects, such as aluminum, nickel, iron, steel, beryllium, zinc, titanium, chromium and the like.

For purposes of this specification, a "phosphorus-containing" compound is any compound containing a phosphorus atom. A preferred phosphorus-containing compound is, for example, a phosphate, pyrophosphate, polyphosphate, phosphonate, including, their acids, salts, mixed acid salts, esters, partial esters, mixed esters, and mixtures thereof, for example, phosphoric acid. In particular, a preferred aqueous polishing composition can be formulated using, for example, the following phosphorus-containing compounds: zinc phosphate, zinc pyrophosphate, zinc polyphosphate, zinc phosphonate, ammonium phosphate, ammonium pyrophosphate, ammonium polyphosphate, ammonium phosphonate, diammonium phosphate, diammonium pyrophosphate, diammonium polyphosphate, diammonium phosphonate, guanidine phosphate, guanidine pyrophosphate, guanidine polyphosphate, guanidine phosphonate, iron phosphate, iron pyrophosphate, iron polyphosphate, iron phosphonate, cerium phosphate, cerium pyrophosphate, cerium polyphosphate, cerium phosphonate, ethylene-diamine phosphate, piperazine phosphate, piperazine pyrophosphate, piperazine phosphonate, melamine phosphate, dimelamine phosphate, melamine pyrophosphate, melamine polyphosphate, melamine phosphonate, melam phosphate, melam pyrophosphate, melam polyphosphate, melam phosphonate, melem phosphate, melem pyrophosphate, melem polyphosphate, melem phosphonate, dicyanodiamide phosphate, urea phosphate, including, their acids, salts, mixed acid salts, esters, partial esters, mixed esters, and mixtures thereof. Also, phosphine oxides, phosphine sulphides and phosphorinanes and of phosphonates, phosphites and phosphinates may be used, including, their acids, salts, mixed acid salts, esters, partial esters and mixed esters. A preferred phosphorus-containing compound is ammonium phosphate.

Advantageously, the phosphorus-containing compound of the polishing composition of the present invention is present in an amount effective to increase polishing rates at low down force pressures. It is believed that even a trace amount of the phosphorus-containing compound in the polishing composition is effective for polishing the copper. A satisfactory polishing rate at acceptable polishing down force pressures is obtained by using the phosphorus-containing compound in an amount of about 0.05 to about 10 weight percent of the composition. A preferred range for the phosphorus-containing compound is about 0.1 to about 5 weight percent of the composition. Most preferably, the phosphorus-containing compound is about 0.3 to about 2 weight percent of the composition.

Advantageously, the novel polishing composition contains about 0.01 to 5 weight percent of a carboxylic acid polymer. Preferably, the composition contains about 0.05 to 2 weight percent of a carboxylic acid polymer. Also, the polymer preferably has a number average molecular weight of about 1,000 to 1,500,000. In addition, blends of higher and lower number average molecular weight carboxylic acid polymers can be used. These carboxylic acid polymers generally are in solution but may be in an aqueous dispersion. The number average molecular weight of the aforementioned polymers are determined by GPC (gel permeation chromatography).

The carboxylic acid polymers are formed from unsaturated monocarboxylic acids and unsaturated dicarboxylic acids. Typical unsaturated monocarboxylic acid monomers contain 3 to 6 carbon atoms and include acrylic acid, oligomeric acrylic acid, methacrylic acid, crotonic acid and vinyl acetic acid. Typical unsaturated dicarboxylic acids contain 4 to 8 carbon atoms and include the anhydrides thereof and are, for example, maleic acid, maleic anhydride, fumaric acid, glutaric acid, itaconic acid, itaconic anhydride, and cyclohexene dicarboxylic acid. In addition, water soluble salts of the aforementioned acids also can be used.

Particularly useful are "poly(meth)acrylic acids" having a number average molecular weight of about 1,000 to 1,500,000 preferably 5,000 to 250,000 and more preferably, 20,000 to 200,000. As used herein, the term "poly(meth)acrylic acid" is defined as polymers of acrylic acid, polymers of methacrylic acid or copolymers of acrylic acid and methacrylic acid. Blends of varying number average molecular weight poly(meth)acrylic acids are particularly preferred. In these blends or mixtures of poly(meth)acrylic acids, a lower number average molecular weight poly(meth)acrylic acid having a number average molecular weight of 1,000 to 100,000 and preferably, 20,000 to 40,000 is used in combination with a higher number average molecular weight poly(meth)acrylic acid having a number average molecular weight of 150,000 to 1,500,000, preferably, 200,000 to 300,000. Typically, the weight percent ratio of the lower number average molecular weight poly(meth)acrylic acid to the higher number average molecular weight poly(meth)acrylic acid is about 10:1 1 to 1:10, preferably 5:1 to 1:5, and more preferably, 3:2 to 2:3. A preferred blend comprises a poly(meth)acrylic acid having a number average molecular weight of about 20,000 and a poly(meth)acrylic acid having a number average molecular weight of about 200,000 in a 2:1 weight ratio.

Advantageously, carboxylic acid containing copolymers and terpolymers can be used in which the carboxylic acid component comprises 5-75% by weight of the polymer. Typical of such polymer are polymers of (meth)acrylic acid and acrylamide or methacrylamide; polymers of (meth)acrylic acid and styrene and other vinyl aromatic monomers; polymers of alkyl (meth)acrylates (esters of acrylic or methacrylic acid) and a mono or dicarboxylic acid, such as, acrylic or methacrylic acid or itaconic acid; polymers of substituted vinyl aromatic monomers having substituents, such as, halogen, i.e., chlorine, fluorine, bromine, nitro, cyano, alkoxy, haloalkyl, carboxy, amino, amino alkyl and a unsaturated mono or dicarboxylic acid and an alkyl (meth)acrylate; polymers of monethylenically unsaturated monomers containing a nitrogen ring, such as, vinyl pyridine, alkyl vinyl pyridine, vinyl butyrolactam, vinyl caprolactam, and an unsaturated mono or dicarboxylic acid; polymers of olefins, such as, propylene, isobutylene, or long chain alkyl olefins having 10 to 20 carbon atoms and an unsaturated mono or dicarboxylic acid; polymers of vinyl alcohol esters, such as, vinyl acetate and vinyl stearate or vinyl halides, such as, vinyl fluoride, vinyl chloride, vinylidene fluoride or vinyl nitriles, such as, acrylonitrile and methacrylonitrile and an unsaturated mono or dicarboxylic acid; polymers of alkyl (meth) acrylates having 1-24 carbon atoms in the alkyl group and an unsaturated monocarboxylic acid, such as, acrylic acid or methacrylic acid. These are only a few examples of the variety of polymers that can be used in the novel polishing composition of this invention. Also, it is possible to use polymers that are biodegradeable, photodegradeable or degradeable by other means. An example of such a composition that is biodegradeable is a polyacrylic acid polymer containing segments of poly(acrylate comethyl 2-cyanoacrylate).

Advantageously, the solution contains 1 to 15 weight percent oxidizer. More preferably, the oxidizer is in the range of 5 to 10 weight percent. The oxidizing agent can be at least one of a number of oxidizing compounds, such as hydrogen peroxide (H₂O₂) monopersulfates, iodates, magnesium perphthalate, peracetic acid and other peracids, persulfates, bromates, periodates, nitrates, iron salts, cerium salts, Mn (III), Mn (IV) and Mn (VI) salts, silver salts, copper salts, chromium salts, cobalt salts, halogens hypochlorites and a mixture thereof. Furthermore, it is often advantageous to use a mixture of oxidizer compounds. When the polishing slurry contains an unstable oxidizing agent such as, hydrogen peroxide, it is often most advantageous to mix the oxidizer into the composition at the point of use.

Further, the solution contains 0.1 to 1.0 weight percent inhibitor to control copper interconnect removal rate by static etch or other removal mechanism. Adjusting the concentration of an inhibitor adjusts the interconnect metal removal rate by protecting the metal from static etch. Advantageously, the solution contains 0.2 to 0.50 weight percent inhibitor. The inhibitor may consist of a mixture of inhibitors. Azole inhibitors are particularly effective for copper and silver interconnects. Typical azole inhibitors include benzotriazole (BTA), mercaptobenzothiazole (MBT), tolytriazole (TTA) and imidazole. BTA is a particularly effective inhibitor for copper and silver.

In addition to the inhibitor, the composition advantageously contains 0.05 to 3 weight percent complexing agent for the nonferrous metal. The complexing agent prevents precipitation of the metal ions by complexing the nonferrous metal interconnects. Advantageously, the composition contains 0.1 to 1 weight percent complexing agent for the nonferrous metal. Example complexing agents include acetic acid, citric acid, ethyl acetoacetate, glycolic acid, lactic acid, malic acid, oxalic acid, salicylic acid, sodium diethyl dithiocarbamate, succinic acid, tartaric acid, thioglycolic acid, glycine, alanine, aspartic acid, ethylene diamine, trimethyl diamine, malonic acid, gluteric acid, 3-hydroxybutyric acid, propionic acid, phthalic acid, isophthalic acid, 3-hydroxy salicylic acid, 3,5-dihydroxy salicylic acid, gallic acid, gluconic acid, pyrocatechol, pyrogallol, tannic acid, including, salts and mixtures thereof. Advantageously, the complexing agent is selected from the group consisting of acetic acid, citric acid, ethyl acetoacetate, glycolic acid, lactic acid, malic acid, oxalic acid and mixtures thereof. Most advantageously, the complexing agent is malic acid.

In addition, the polishing composition of this invention contains 0.01 to 5.0 weight percent of modified cellulose. Preferably, the composition contains 0.1 to 3 weight percent of modified cellulose. The addition of modified cellulose (for e.g. carboxymethyl cellulose) provides unexpected reduction of dishing values to the polishing composition. Exemplary modified cellulose are anionic gums such as agar gum, arabic gum, ghatti gum, karaya gum, guar gum, pectin, locust bean gum, tragacanth gums, tamarind gum, carrageenan gum, xantham gum, modified starch, alginic acid, mannuronic acid, guluronic acid, and their modifications and combinations.

The composition and method provide unexpected increase in polishing rates of copper interconnects at reduced down force pressures. In particular, the composition and method provide unexpected increase in polishing rates of copper interconnects at down force pressures of at least less than 3 psi (20.68 kPa). More particularly, the composition and method provide unexpected increase in polishing rates of copper interconnects at down force pressures of 1 psi (6.89 kPa) and less. The polishing composition or fluid of the present invention utilizes the addition of phosphorus-containing compounds to effectively increase polishing rates during first step polishing of copper interconnects on the wafer at low down force pressures of 1 psi and less. The aqueous composition comprises an oxidizer, inhibitor, complexing agent, polymers and phosphorus-containing compounds, and balance water. In addition, the present composition provides a substantial reduction in dishing of the copper circuits of the wafer in comparison to conventional polishing compositions. The novel polishing composition provides a substantially planar surface that is free of scratches and other defects that commonly result from polishing. The present composition is particularly useful in ultra low k dielectric film applications.

The compounds provide efficacy over a broad pH range in solutions containing a balance of water. This solution's useful pH range extends from at least 2 to 5. In addition, the solution advantageously relies upon a balance of deionized water to limit incidental impurities. The pH of the polishing fluid of this invention is preferably from 2.5 to 4.2, more preferably a pH of 2.6 to 3.8. The acids used to adjust the pH of the composition of this invention are, for example, nitric acid, sulfuric acid, hydrochloric acid, phosphoric acid and the like. Exemplary bases used to adjust the pH of the composition of this invention are, for example, ammonium hydroxide and potassium hydroxide. Advantageously, the addition of the phosphorus-containing compound provides greater stability and robustness to the present composition. In particular, the addition of the phosphorus-containing compound allows the present composition to provide effective polishing rates, substantially unaffected or independent of the pH.

Further, the polishing composition may optionally contain 0 to 10 weight percent abrasive to facilitate metal layer removal. Within this range, it is desirable to have the abrasive present in an amount of greater than or equal to 0.01 weight percent. Also, desirable within this range is an amount of less than or equal to 1 weight percent.

The abrasive has an average particle size of less than or equal to 50 nanometers (nm) for preventing excessive metal dishing, dielectric erosion and improving planarization. For purposes of this specification, particle size refers to the average particle size of the abrasive. More preferably, it is desirable to use a colloidal abrasive having an average particle size of less than or equal to 40 nm. Further, minimal dielectric erosion and metal dishing advantageously occurs with colloidal silica having an average particle size of less than or equal to 30 nm. Decreasing the size of the colloidal abrasive to less than or equal to 30 nm, tends to improve the selectivity of the polishing composition, but, it also tends to decrease the removal rate. In addition, the preferred colloidal abrasive may include additives, such as dispersants, surfactants and buffers to improve the stability of the colloidal abrasive. One such colloidal abrasive is colloidal silica from Clariant S.A., of Puteaux, France. Also, other abrasives, including, those that are fumed, precipitated, agglomerated, etc., may be utilized.

The polishing composition may include the abrasive for "mechanical" removal of metal interconnect layers. Example abrasives include inorganic oxides, inorganic hydroxides, inorganic hydroxide oxides, metal borides, metal carbides, metal nitrides, polymer particles and mixtures comprising at least one of the foregoing. Suitable inorganic oxides include, for example, silica (SiO₂), alumina (Al₂O₃), zirconia (ZrO₂), ceria (CeO₂), manganese oxide (MnO₂), titanium oxide (TiO₂) or combinations comprising at least one of the foregoing oxides. Suitable inorganic oxides include, for example, aluminum hydroxide oxide ("boehmite"). Modified forms of these inorganic oxides, such as, polymer-coated inorganic oxide particles and inorganic coated particles may also be utilized if desired. Suitable metal carbides, boride and nitrides include, for example, silicon carbide, silicon nitride, silicon carbonitride (SiCN), boron carbide, tungsten carbide, zirconium carbide, aluminum boride, tantalum carbide, titanium carbide, or combinations comprising at least one of the foregoing metal carbides, boride and nitrides. Diamond may also be utilized as an abrasive if desired. Alternative abrasives also include polymeric particles and coated polymeric particles. The preferred abrasive, if utilized, is silica.

The composition of the present invention is applicable to any semiconductor wafer containing a conductive metal, such as copper, aluminum, tungsten, platinum, palladium, gold, or iridium; a barrier or liner film, such as tantalum, tantalum nitride, titanium, or titanium nitride; and an underlying dielectric layer. For purposes of the specification, the term dielectric refers to a semi-conducting material of dielectric constant, k, which includes low-k and ultra-low k dielectric materials. The composition and method are excellent for preventing erosion of multiple wafer constituents, for example, porous and nonporous low-k dielectrics, organic and inorganic low-k dielectrics, organic silicate glasses (OSG), fluorosilicate glass (FSG), carbon doped oxide (CDO), tetraethylorthosilicate (TEOS) and a silica derived from TEOS.

### Examples

In the Examples, numerals represent examples of the invention and letters represent comparative examples. All example solutions contained, by weight percent, 0.50 BTA, 0.22 malic acid, 0.32 carboxymethyl cellulose (CMC), 0.10 copoly(methacrylic acid /acrylic acid) (200 k mw) having a monomeric molar ratio of 3:2 and 9.00 hydrogen peroxide.

### Example 1

This experiment measured polishing rates of bulk copper from a semiconductor wafer at low down force pressures. In particular, the test determined the effect of the addition of phosphorus-containing compounds to the polishing rate during a first step polishing operation at 1 psi. An Applied Materials, Inc. Mirra 200mm polishing machine using an IC1010™ microporous polyurethane polishing pad (Rodel, Inc.) under downforce pressure conditions of about 1 psi (6.89 kPa) and a polishing solution flow rate of 160 cc/min, a platen speed of 80 RPM and a carrier speed of 75 RPM planarized the samples. The samples were 200 mm copper blanket wafers. The polishing solutions had a pH of 2.8 adjusted with nitric acid. All solutions contained deionized water.

**Table 1**

| Polishing Results | | | |
|---|---|---|---|
| Test | Ammonium Phosphate (Wt%) | Down Force Pressure (kPa) | Removal Rate (Å/min) |
| A | -- | 6.89 | 1500 |
| 1 | 0.10 | 6.89 | 2663 |
| 2 | 0.50 | 6.89 | 3310 |
| 3 | 1.00 | 6.89 | 3441 |

As illustrated in Table 1, the addition of the phosphorus-containing compound increased the removal rate of the copper at low down force pressures. In particular, the addition of ammonium phosphate increased the removal rate of the copper at down force pressures of 6.89 kPa. For example, the removal rate was increased from 1500 Å/min in Test A which did not contain any ammonium phosphate to 2663 Å/min, 3310 Å/min, 3441 Å/min, with the addition of 0.10, 0.50, 1.00 weight percent of ammonium phosphate, respectively. All of the increase in removal rate was demonstrated at a down force pressure of 6.89 kPa.

The composition and method provide unexpected increase in polishing rates of copper interconnects at reduced down force pressures. In particular, the composition and method provide unexpected increase in polishing rates of copper interconnects at down force pressures of at least less than 3 psi (20.68 kPa). More particularly, the composition and method provide unexpected increase in polishing rates of copper interconnects at down force pressures of 1 psi (6.89 kPa) and less. The abrasive-free polishing composition or fluid of the present invention utilizes the addition of phosphorus-containing compounds to effectively increase polishing rates during first step polishing of copper interconnects on the wafer at low down force pressures of 1 psi and less.

## Claims

1. An aqueous composition useful for polishing copper on a semiconductor wafer at a down force pressure of at least less than 20.68 kPa, comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive, wherein the phosphorus-containing compound increases removal of the copper.

2. The composition of claim 1 wherein the phosphorus-containing compound is selected from group comprising: phosphate, pyrophosphate, polyphosphate, phosphonate, and their acids, salts, mixed acid salts, esters, partial esters, mixed esters, and mixtures thereof.

3. The composition of claim 1 wherein the phosphorus-containing compound is selected from the group comprising: zinc phosphate, zinc pyrophosphate, zinc polyphosphate, zinc phosphonate, ammonium phosphate, ammonium pyrophosphate, ammonium polyphosphate, ammonium phosphonate, diammonium phosphate, diammonium pyrophosphate, diammonium polyphosphate, diammonium phosphonate, guanidine phosphate, guanidine pyrophosphate, guanidine polyphosphate, guanidine phosphonate, iron phosphate, iron pyrophosphate, iron polyphosphate, iron phosphonate, cerium phosphate, cerium pyrophosphate, cerium polyphosphate, cerium phosphonate, ethylene-diamine phosphate, piperazine phosphate, piperazine pyrophosphate, piperazine phosphonate, melamine phosphate, dimelamine phosphate, melamine pyrophosphate, melamine polyphosphate, melamine phosphonate, melam phosphate, melam pyrophosphate, melam polyphosphate, melam phosphonate, melem phosphate, melem pyrophosphate, melem polyphosphate, melem phosphonate, dicyanodiamide phosphate, urea phosphate, and their acids, salts, mixed acid salts, esters, partial esters, mixed esters, and mixtures thereof.

4. The composition of claim 1 wherein the composition comprises 0.3 to 2 weight percent of the phosphorus-containing compound.

5. The composition of claim 1 wherein the carboxylic acid polymer comprises a blend of a poly(meth)acrylic acid, the blend comprising a first polymer having a number average molecular weight of 1,000 to 100,000 and at least a second polymer having a number average molecular weight of 150,000 to 1,500,000, the first and second polymers having a weight percent ratio of 10:1 to 1:10.

6. The composition of claim 5 wherein the first polymer has a number average molecular weight of 20,000 and the second polymer has a number average molecular weight of 200,000, the first and second polymers having a weight percent ratio of 2:1.

7. The composition of claim 1 wherein the modified cellulose is carboxymethyl cellulose.

8. An aqueous composition useful for polishing copper on a semiconductor wafer comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive, wherein the phosphorus-containing compound increases removal of the copper to at least 1500 Å/min as measured with a microporous polyurethane polishing pad pressure measured normal to the wafer of 6.89 kPa.

9. A method for polishing copper from a semiconductor wafer comprising:
contacting the wafer with a polishing composition, the wafer containing the copper, the polishing composition comprising by weight percent 1 to 15 oxidizer, 0.1 to 1 inhibitor for a nonferrous metal, 0.05 to 3 complexing agent for the nonferrous metal, 0.01 to 5 carboxylic acid polymer, 0.01 to 5 modified cellulose, 0.05 to 10 phosphorus-containing compound and 0 to 10 abrasive;
pressing the wafer with a polishing pad at a down force pressure of at least less than 20.68 kPa; and
polishing the wafer with the polishing pad, wherein the phosphorus-containing compound increases removal of the copper.

10. The method of claim 9 wherein the phosphorus-containing compound is selected from the group comprising: zinc phosphate, zinc pyrophosphate, zinc polyphosphate, zinc phosphonate, ammonium phosphate, ammonium pyrophosphate, ammonium polyphosphate, ammonium phosphonate, diammonium phosphate, diammonium pyrophosphate, diammonium polyphosphate, diammonium phosphonate, guanidine phosphate, guanidine pyrophosphate, guanidine polyphosphate, guanidine phosphonate, iron phosphate, iron pyrophosphate, iron polyphosphate, iron phosphonate, cerium phosphate, cerium pyrophosphate, cerium polyphosphate, cerium phosphonate, ethylene-diamine phosphate, piperazine phosphate, piperazine pyrophosphate, piperazine phosphonate, melamine phosphate, dimelamine phosphate, melamine pyrophosphate, melamine polyphosphate, melamine phosphonate, melam phosphate, melam pyrophosphate, melam polyphosphate, melam phosphonate, melem phosphate, melem pyrophosphate, melem polyphosphate, melem phosphonate, dicyanodiamide phosphate, urea phosphate, and their acids, salts, mixed acid salts, esters, partial esters, mixed esters, and mixtures thereof.
